# FASCICULE DE BREVET EUROPEEN

(11) **EP 3 364 204 B1**
(45) Date de publication et mention de la délivrance du brevet: **11.09.2019**
(21) Numéro de dépôt: 18156363.6
(22) Date de dépôt: 12.02.2018
(51) Int. Cl.: G01R 33/26

(54) **MAGNÉTOMÈTRE ASSERVI EN CHAMP NUL PAR EFFET STARK ALTERNATIF**
MITTELS AC-STARK-EFFEKT KONTROLLIERTES NULLFELD-MAGNETOMETER
ZERO FIELD MAGNETOMETER CONTROLLED BY AC STARK EFFECT

(30) Priorité: 15.02.2017 FR 1751217
(43) Date de publication de la demande: 22.08.2018
(73) Titulaire: Commissariat à l'énergie atomique et aux énergies alternatives, 75015 Paris (FR)
(72) Inventeur: PALACIOS LALOY, Augustin, 38000 GRENOBLE (FR)
(74) Mandataire: Brevalex

(56) Documents cités:
- US-A1- 2016 116 553
- B. PATTON ET AL: "All-Optical Vector Atomic Magnetometer", PHYSICAL REVIEW LETTERS, vol. 113, no. 1, 4 juillet 2014 (2014-07-04), pages 013001-1-013001-5, XP055429366, US ISSN: 0031-9007, DOI: 10.1103/PhysRevLett.113.013001
- ZHIVUN ELENA ET AL: "Alkali-vapor magnetic resonance driven by fictitious radiofrequency fields", APPLIED PHYSICS LETTERS, A I P PUBLISHING LLC, US, vol. 105, no. 19, 10 novembre 2014 (2014-11-10), XP012191880, ISSN: 0003-6951, DOI: 10.1063/1.4902028 [extrait le 1901-01-01]

## Description

### DOMAINE TECHNIQUE

Le domaine de l'invention est celui des magnétomètres à pompage optique asservis en champ nul. L'invention trouve application dans l'imagerie des champs biomagnétiques, par exemple en magnétocardiographie ou en magnétoencéphalographie, notamment au moyen de magnétomètres utilisés en réseau.

### ÉTAT DE LA TECHNIQUE ANTÉRIEURE

Les magnétomètres à pompage optique sont basés sur une résonance magnétique entre raies Zeeman amplifiée à l'aide d'un pompage optique. Ces magnétomètres utilisent des gaz atomiques confinés dans une cellule (typiquement de l'hélium métastable ou des gaz d'alcalins) en tant qu'éléments sensible.

Ces magnétomètres, qui peuvent prendre différentes configurations, permettent de remonter au champ magnétique en exploitant les trois processus suivants qui ont lieu de façon soit séquentielle soit concomitante :
1) L'utilisation de sources de lumière polarisée (typiquement des lasers) permet de préparer des états atomiques caractérisés par une certaine orientation ou alignement de leurs spins.
2) Ces états évoluent de manière comprise sous l'effet du champ magnétique, notamment sous l'effet Zeeman (décalages des niveaux d'énergie dépendant du champ magnétique).
3) Les propriétés optiques du milieu atomique subissent des modifications qui dépendent de l'état des atomes. On peut ainsi par une mesure optique (par exemple d'absorption) remonter au décalage Zeeman subi, et de là au champ magnétique dans lequel est plongée la cellule.

Selon les différentes configurations possibles, il est alors possible de déduire soit le module (pour les magnétomètres scalaires), soit les différentes composantes du champ magnétique (pour les magnétomètres vectoriels) à l'emplacement de la cellule.

Le niveau de sensibilité (aussi appelé bas bruit) et de justesse atteignables avec des tels magnétomètres sont très remarquables et nettement plus favorables que ceux de la plupart des autres technologies de mesure magnétique (fluxgate, effet Hall, magnétorésistance, etc.). Seul le magnétomètre de type SQUID possède un bruit semblable, mais il requiert un refroidissement cryogénique de l'élément sensible (à l'aide de supraconducteurs), ce qui restreint son champ d'application pratique.

Pour réaliser une mesure vectorielle du champ magnétique avec une bande passante large, il existe deux configurations bien connues : la première dite « à effet Hanle » et la deuxième qui reçoit le nom de « magnétomètre à résonance paramétrique ». Ces configurations sont décrites notamment dans l'article de J. Dupont-Roc, "Détermination par des méthodes optiques des trois composantes d'un champ magnétique très faible," Revue de Physique Appliquée, vol. 5, no. 6, pp. 853-864, 1970. Elles fonctionnent à des valeurs de champ magnétique extérieur très faible (induisant un décalage Zeeman plus faible que le taux de relaxation des sous-niveaux Zeeman de l'atome, ce qui pour le cas de l'hélium-4 fixe une limite autour de 100 nT, 500 fois moins intense que le champ magnétique terrestre).

Lorsqu'un champ faible statique transverse est appliqué à la cellule et balayé autour de zéro, les atomes sous soumis à un mouvement de précession et le nombre de photons absorbés provenant du laser de pompage otique subit des variations résonantes (effet Hanle). Des résonances analogues appelées résonances paramétriques (i.e., en présence de champs magnétiques modulés en fréquence) sont observées lorsqu'un champ RF, colinéaire au champ ambiant et orthogonal à la direction de polarisation des photons, est appliqué. Dans ces conditions, le moment magnétique de chaque atome subit des oscillations résonantes aux fréquences multiples de celle du champ RF d'excitation. La mesure de l'amplitude de ces oscillations permet de remonter au module du champ magnétique colinéaire au champ RF.

Dans ces deux configurations, il est avantageux de faire fonctionner le magnétomètre « en boucle fermée » en venant constamment soumettre l'élément sensible à un champ magnétique total nul. Ce fonctionnement avec asservissement en champ nul présente notamment l'avantage d'être moins sensible à la variation de paramètres expérimentaux (puissances laser, densité de l'élément sensible...).

Le champ magnétique total nul est obtenu en générant des champs magnétiques de compensation par injection de courants dans des bobines appropriées qui entourent l'élément sensible. Ces champs de compensation viennent annuler chacune des composantes du champ magnétique ambiant au moyen d'une régulation en boucle fermée des courants injectés. La mesure des courants circulant dans les bobines permet de déduire les champs qu'il est nécessaire d'appliquer pour annuler les différentes composantes du champ ambiant, et donc de disposer de la valeur de ces différentes composantes.

Toutefois, dans des nombreux environnements l'asservissement en champ nul d'un magnétomètre peut être nuisible. Cela est notamment le cas lorsque l'on exploite des magnétomètres agencés selon un réseau matriciel dédié à la reconstruction de sources magnétiques (par exemple pour l'imagerie des courants nerveux ou cardiaques). En effet, l'application de champs de compensation sur un magnétomètre impacte les champs vus par les magnétomètres voisins (effet de diaphonie) et perturbe donc les mesures effectuées par les magnétomètres voisins. Dans d'autres applications (couplage à des capteurs magnétostrictifs par exemple), l'effet des champs de compensation peut perturber les phénomènes qu'on cherche à observer.

### EXPOSÉ DE L'INVENTION

Un objectif de l'invention est de permettre de faire fonctionner un magnétomètre à pompage optique en régime « champ nul » sans pour autant avoir à générer des champs magnétiques de compensation, et ce alors que les champs ambiants à compenser sont significativement supérieurs à 100 nT.

A cet effet, l'invention propose un magnétomètre comprenant une cellule remplie d'un gaz soumis à un champ magnétique ambiant, une source de pompage optique apte à émettre en direction de la cellule un faisceau laser accordé à une longueur d'onde de pompage, un photodétecteur recevant le faisceau laser ayant traversé la cellule et un système d'asservissement en boucle fermé du magnétomètre pour le faire fonctionner en champ nul. Le système d'asservissement comprend :
- une cavité optique délimitée par des miroirs dans laquelle est agencée la cellule,
- une source d'excitation optique configurée pour éclairer la cavité optique avec un faisceau polarisé circulairement et accordé à une longueur d'onde d'excitation décalée par rapport à la longueur d'onde de pompage de manière à permettre d'induire dans la cellule, par effet Stark, l'équivalent d'un champ magnétique orienté selon une direction de propagation de la lumière dans la cavité optique, et
- un régulateur de boucle fermée couplé au photodétecteur et configuré pour piloter la source d'excitation optique de manière à ce qu'elle induise dans la cellule l'équivalent d'un champ magnétique de compensation opposé au champ magnétique ambiant dans ladite direction de propagation de la lumière.

Certains aspects préférés mais non limitatifs de ce magnétomètre sont les suivants :
- la cavité optique est une cavité résonante accordée à la longueur d'onde d'excitation de la source d'excitation optique ;
- la cavité optique est une cavité multi passages ;
- les miroirs de la cavité optique sont formés sur les parois de la cellule ;
- la cavité optique est agencée de manière à ce que la direction de propagation de la lumière dans la cavité optique corresponde avec un axe de mesure du magnétomètre ;
- la source d'excitation optique comprend un laser configuré pour délivrer un faisceau laser accordé à la longueur d'onde d'excitation et un polariseur circulaire ;
- l'écart entre la longueur d'onde de pompage et la longueur d'onde d'excitation est compris entre 0,25 et 2,5 fois la largeur optique à mi-hauteur de la raie de la transition atomique activée par la source de pompage optique ;
- la source d'excitation optique comprend un laser configuré pour délivrer un faisceau laser accordé à la longueur d'onde de pompage et un modulateur optique apte à décaler la longueur d'onde du faisceau laser de la longueur d'onde de pompage vers la longueur d'onde d'excitation ;
- en sortie du modulateur, le faisceau laser présente deux bandes latérales de longueur d'onde respectivement au-dessus et au-dessous de la longueur d'onde de pompage, et la distance entre les deux bandes latérales est comprise entre 0,5 et 5 fois la largeur optique à mi-hauteur de la raie de la transition atomique activée par la source de pompage optique ;
- la source d'excitation optique comprend en outre un filtre optique pour filtrer l'une des deux bandes latérales et un polariseur pour polariser circulairement la bande latérale non filtrée ;
- la source d'excitation optique comprend en outre deux filtres polarisants et une lame quart d'onde agencés en cascade, les deux filtres polarisants consistant en un premier polariseur linéaire apte à polariser verticalement l'une des bandes latérales et en un second polariseur linéaire apte à polariser horizontalement l'autre des bandes latérales, la lame quart d'onde venant polariser circulairement chacune des bandes latérales respectivement dans le sens anti-horaire et dans le sens horaire ;
- le régulateur comprend un intégrateur ;
- il comprend trois cavités optiques chacune associée à un axe de mesure du magnétomètre et éclairée par sa propre source d'excitation optique.

L'invention porte également sur un dispositif de magnétométrie comprenant un réseau de magnétomètres chacun conforme à l'invention, ainsi que sur un procédé d'asservissement en champ nul d'un magnétomètre.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
- la figure 1 est un schéma d'un magnétomètre conforme à l'invention ;
- la figure 2 est un schéma représentant une mise en oeuvre possible de la régulation de boucle fermée selon l'invention.

### EXPOSÉ DÉTAILLÉ DE MODES DE RÉALISATION PARTICULIERS

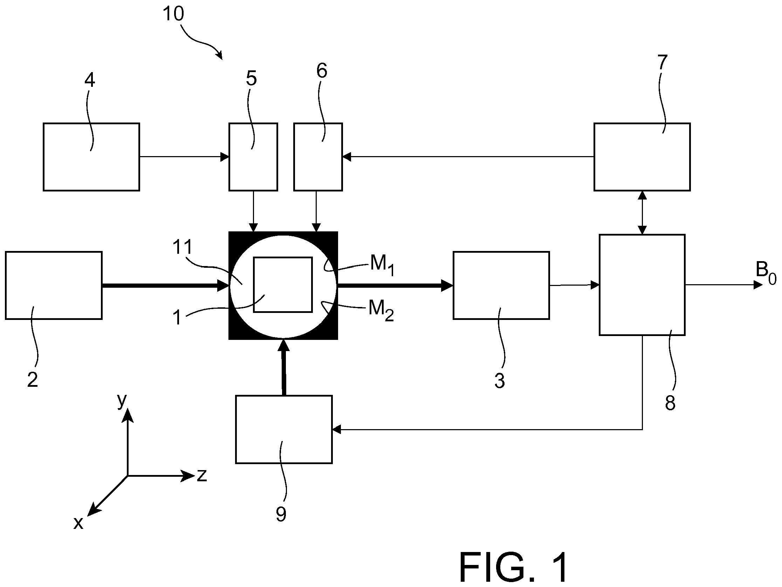

En référence à la figure 1, l'invention porte sur un magnétomètre à pompage optique 10. Le magnétomètre 10 comprend une cellule 1 remplie d'un gaz, par exemple de l'hélium-4 ou un gaz alcalin, soumis à un champ magnétique ambiant B₀. Le champ magnétique ambiant B₀ se décompose en trois composantes Bx, By et Bz chacune selon l'un des axes de mesure du magnétomètre x, y et z.

La cellule est éclairée par une source de pompage optique 2 apte à émettre en direction de la cellule un faisceau laser accordé à une longueur d'onde de pompage. La longueur d'onde de pompage est calée sur une raie de transition atomique, par exemple sur la raie D₀ à 1083 nm dans le cas de l'hélium-4. Le faisceau de pompe peut être polarisé rectilignement selon la direction z au moyen d'un polariseur rectiligne (non représenté). Un photodétecteur 3 reçoit le faisceau laser ayant traversé la cellule.

Dans le cas où l'élément sensible est l'hélium-4, le magnétomètre 10 comporte par ailleurs un système de décharge HF, comprenant un générateur HF 4 et des bobines de surtension 5. Il comprend également un générateur de fréquence RF 7 qui alimente deux bobines 6 d'axes orthogonaux qui entourent la cellule. Les bobines 6 génèrent deux champs RF orthogonaux à la direction de polarisation du faisceau de pompe. On retrouve ainsi un champ RFx et un champ RFy sur les axes x et y de pulsations respectives Ω et ω.

Dans ces conditions, le moment magnétique de chaque atome dans la cellule subit des oscillations résonantes aux fréquences multiples de celle des champs RF d'excitation. L'amplitude des oscillations permet de mesurer le module du champ magnétique colinéaire au champ de radiofréquence. Plus particulièrement, le champ RFx oscillant à la pulsation Ω est orienté suivant l'axe x et le champ RFy oscillant à la pulsation ω est orienté suivant l'axe y. Il en résulte alors une modulation de la lumière transmise notamment aux pulsations Ω, w et Ω±ω. Ces signaux sont respectivement proportionnels aux composantes du champ magnétique total au niveau de la cellule.

Le magnétomètre 10 comporte par ailleurs une carte électronique de traitement 8 qui traite le signal électrique en sortie du photodétecteur 8 pour fournir les valeurs des composantes Bₓ, B_{y} et B_{z} du champ ambiant B₀. La carte 8 vient également asservir le générateur de fréquence RF 7 et piloter l'asservissement en boucle fermé du magnétomètre pour le faire fonctionner en champ nul.

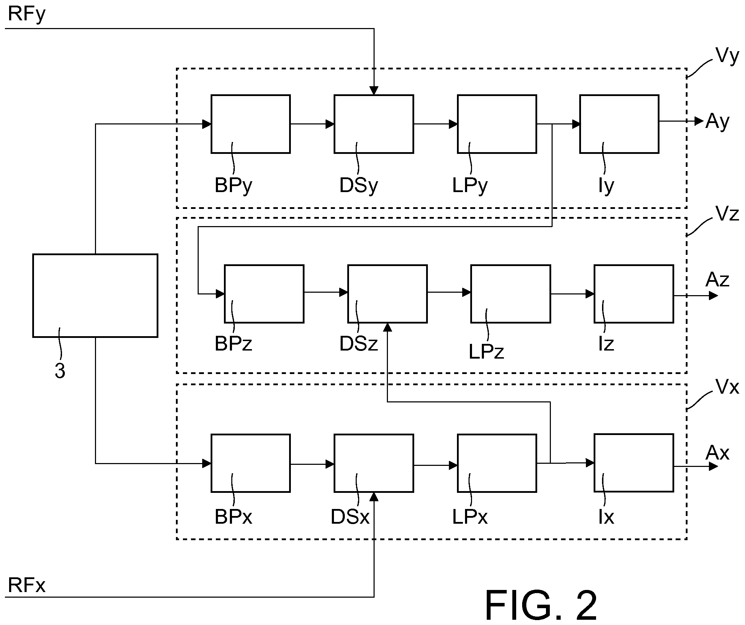

Une fois la cellule allumée grâce au système de décharge HF, le faisceau optique traversant la cellule est converti en signal électrique par l'intermédiaire du photodétecteur 3. Comme représenté sur la figure 2, la carte électronique de traitement 8 comprend un régulateur de boucle fermée qui vient séparer le signal résultant en trois voies : une première voie Vx pour la détection du signal à Ω /2π (axe x), une second voie Vy pour la détection du signal à ω/2π (axe y), et une troisième voie Vz pour la détection du signal à Ω±ω/2 π (axe z). Le signal sur chacune des première et deuxième voies est d'abord amplifié puis filtré avec un filtre passe-bande BPx, BPy correspondant à la fréquence centrale adéquate (i.e. correspondant à celle du champ RF appliqué, respectivement RFx et RFy). Le signal obtenu est alors multiplié par un signal de référence et traité par un détecteur synchrone DSx, DSy suivi d'un filtre passe-bas LPx, LPy.

La troisième voie Vz utilise deux détections synchrones en série (à ω/2π puis Ω /2π) pour remonter à la résonance modulée en amplitude aux fréquences Ω ±ω/2 π (axe Z). On y retrouve un filtre passe-bande BPz, un détecteur synchrone DSz et un filtre passe-bas LPz.

Chacune de ces trois voies Vx, Vy, Vz comprend un intégrateur Ix, Iy, Iz permettant d'assurer la régulation en boucle fermée au moyen de laquelle le système s'asservit en champ nul. Ici, la régulation en boucle fermée ne vient pas piloter l'injection de courant dans un jeu de trois bobines orthogonales pour générer des champs magnétiques de compensation du champ ambiant. Selon l'invention en effet, on exploite l'effet Stark pour induire à l'aide d'excitations optiques l'équivalent de ces champs de compensation.

Plus particulièrement, l'invention exploite le phénomène recevant l'appellation de « lightshift » (ou de décalage Stark alternatif, ou encore de champ magnétique fictif induit par la lumière) selon lequel des excitations optiques en polarisation circulaire et légèrement décalées par rapport aux raies de résonances atomiques induisent un comportement équivalent à celui d'un champ magnétique statique. Ce phénomène est notamment décrit de façon quantitative dans l'article W. Happer and B. S. Mathur, "Effective Operator Formalism in Optical Pumping," Phys. Rev., vol. 163, no. 1, pp. 12-25, Nov. 1967.

Le magnétomètre 10 selon l'invention intègre une telle source d'excitation optique pour chaque axe de mesure utile, soit trois sources au total, de manière à induire un champ fictif Bcfₓ, Bcf_{y} et Bcf_{z} sur chacun des trois axes de mesure x, y et z.

Ainsi, le magnétomètre 10 comprend un système d'asservissement en boucle fermé du magnétomètre pour le faire fonctionner en champ nul qui comprend ces sources d'excitation optique, lesquelles sont pilotées par un régulateur de boucle fermée couplé au photodétecteur 3 de manière à induire des champs fictifs Bcfₓ, Bcf_{y} et Bcf_{z} tels que Bcfₓ = -Bₓ, Bcf_{y} = -B_{y} et Bcf_{z} = -B_{z}. Dans le cadre de l'invention, les intégrateurs Ix, Iy et Yz du régulateur de boucle fermée de la carte de traitement 8 fournissent des signaux de contrôle Ax, Ay et Ay aux sources d'excitation optique permettant d'assurer le fonctionnement en champ nul. Il s'agit notamment de signaux de contrôle relatifs à l'amplitude des faisceaux lumineux délivrés par ces sources d'excitation.

Une difficulté réside néanmoins dans le fait que l'intensité de la lumière nécessaire pour induire l'équivalent des champs magnétiques de compensation habituellement utilisés est très élevée. Par exemple, pour le cas de l'hélium, l'intensité de la lumière nécessaire pour induire un champ fictif de l'ordre du champ terrestre est de plusieurs W/cm². Cela demande de disposer de sources de forte intensité (l'intensité des sources typiquement utilisées dans les magnétomètres à pompage optique étant de quelques dizaines de mW). Cela induit en outre une forte consommation électrique, particulièrement pour les réseaux (matrices) de magnétomètres qui comptent plusieurs dizaines, voire centaines de magnétomètres. Enfin, la puissance lumineuse de ces faisceaux doit être dissipée, ce qui induit un échauffement des matériaux environnant la cellule, et donc une difficulté accrue pour la stabilisation thermique de celle-ci.

Afin de contourner cette difficulté, l'invention propose de jouer sur le couplage de la lumière avec les atomes de manière à rendre plus efficace la compensation « tout optique » par effet Stark. Pour cela, la cellule renfermant l'élément sensible est disposé au sein d'un ensemble de cavités optiques (une cavité pour chaque axe de mesure utile, donc un maximum de trois). En effet le confinement de la lumière dans ces cavités a pour effet d'augmenter le couplage entre la lumière et les atomes, ce qui permet d'induire des champs fictifs significatifs (des dizaines de µT) avec des amplitudes lumineuses faibles (quelques mW ou dizaines de mW) à la sortie des différentes sources d'excitation.

Ainsi, dans le cadre de l'invention et en référence à la figure 1, le dispositif d'asservissement en boucle fermé du magnétomètre pour le faire fonctionner en champ nul comprend une cavité optique 11 délimitée par des miroirs M1, M2 dans laquelle est agencée la cellule 1. La lumière se propage selon une direction de propagation dans la cavité optique 11.

Le dispositif d'asservissement comprend en outre une source d'excitation optique 9 configurée pour éclairer l'au moins une cavité optique 11 avec un faisceau polarisé circulairement et accordé à une longueur d'onde d'excitation décalée par rapport à la longueur d'onde de pompage. Un tel faisceau permet d'induire dans la cellule, par effet Stark, l'équivalent d'un champ magnétique orienté selon la direction de propagation de la lumière dans la cavité optique.

Le dispositif d'asservissement est complété du régulateur précédemment cité qui vient piloter la source d'excitation optique de manière à ce qu'elle induise dans la cellule l'équivalent d'un champ magnétique de compensation opposé à la composante du champ magnétique ambiant dans ladite direction de propagation de la lumière.

De préférence, la cavité optique est agencée de manière à ce que la direction de propagation de la lumière dans la cavité optique corresponde avec un axe de mesure du magnétomètre. Et on retrouve bien entendu de préférence trois cavités optiques chacune associée à un axe de mesure du magnétomètre et éclairée chacune par sa propre source d'excitation optique.

La cavité optique est plus particulièrement délimitée par un miroir semi-réfléchissant côté source d'excitation et par un miroir totalement réfléchissant. Ces miroirs peuvent être des des filtres interférométriques réalisés par un empilement de couches minces (au sens où leur épaisseur est inférieure à la longueur d'onde de la lumière) de deux matériaux présentant un contraste d'indice important (par exemple le dioxyde de titane et le dioxyde de silicium). Dans l'empilement, on alterne les couches de chacun des matériaux avec une distribution d'épaisseurs calculée selon des techniques bien connues dans le domaine, avec pour but par exemple de réfléchir la longueur d'onde de la lumière utilisée pour la compensation par effet Stark, mais de transmettre un niveau substantiel de celle utilisée pour le pompage optique des atomes.

Dans un mode de réalisation possible, la cavité optique est une cavité résonante accordée à la longueur d'onde d'excitation de la source d'excitation optique. Il s'agit par exemple d'une cavité Fabry-Perot dont la transmittance en fonction de la longueur d'onde présente des pics régulièrement espacés.

Dans un autre mode de réalisation possible, la cavité optique est une cavité multi passages qui se distingue d'une cavité résonnante en ce qu'il n'existe pas d'interférences entre les différents passages de la lumière. Dans une telle cavité, la direction de propagation de la lumière correspond à la moyenne des directions de propagation de chacun des passages, la moyenne étant pondérée en fonction de l'intensité lumineuse sur chacun des passages.

Les miroirs de la cavité optique peuvent être formés directement sur les parois de la cellule, celles-ci ayant été soumise à un traitement réfléchissant, par exemple un filtre interférométrique réalisé par un empilement de couches minces tel que celui décrit plus haut déposé directement sur les parois de la cellule. On peut procéder à un dépôt, par exemple par des procédés d'évaporation ou de pulvérisation, sur les éléments de verre qui constitueront les parois de la cellule avant que ceux-ci soient assemblés par collage moléculaire ou par soudure thermique pour constituer un conteneur fermé et étanche.

La source d'excitation optique 9 peut comprendre un laser configuré pour délivrer un faisceau laser accordé à la longueur d'onde d'excitation et un polariseur circulaire. On peut prévoir que l'écart entre la longueur d'onde de pompage et la longueur d'onde d'excitation soit compris entre 0,25 et 2,5 fois, de préférence entre 0,35 et 1,5 fois, de préférence 0,5 fois, la largeur optique à mi-hauteur de la raie de la transition atomique activée par la source de pompage optique.

Alternativement, la source d'excitation optique 9 comprend un laser configuré pour délivrer un faisceau laser accordé à une longueur d'onde d'accord et un modulateur optique apte à décaler la longueur d'onde du faisceau laser de la longueur d'onde d'accord vers la longueur d'onde d'excitation. En sortie du modulateur, le faisceau laser présente deux bandes latérales de longueur d'onde respectivement au-dessus et au-dessous de la longueur d'onde d'accord à λ_{c}±Δλ, où λ_{c} correspond à la longueur d'onde de d'accord et Δλ représente l'écart entre la longueur d'onde d'excitation et la longueur d'onde de pompage.

La distance entre les deux bandes latérales 2^{∗}Δλ est de préférence comprise entre 0,5 et 5 fois, encore plus de préférence entre 0,7 et 3 fois, et encore plus de préférence égale à, la largeur optique à mi-hauteur de la raie de la transition atomique activée par la source de pompage optique.

La longueur d'onde d'accord peut correspondre à la longueur d'onde de pompage, auquel cas la raie de transition atomique se situe à égale distance des bandes latérales. Pour que le laser soit accordé à la longueur d'onde de la transition atomique utilisée pour le pompage optique, sa longueur d'onde est asservie selon des procédés bien connus dans le domaine de la physique atomique, notamment un procédé basé sur le dichroïsme de la vapeur atomique connu en anglais comme DAVLL pour « Dichroic Atomic Vapor Laser Lock » et décrit par exemple dans la publication suivante : B. Chéron, H. Gilles, J. Hamel, O. Moreau, and H. Sorel, "Laser frequency stabilization using Zeeman effect," Journal de Physique III, vol. 4, no. 2, pp. 401-406, 1994.

La bande latérale au-dessus de la longueur d'onde d'accord permet d'induire un champ fictif dont le signe est opposé au champ fictif induit par la bande latérale au-dessus de la longueur d'onde d'accord.

Aussi, dans un mode de réalisation, la source d'excitation optique comprend en outre un filtre optique, réalisé par exemple par un filtre interférométrique tel que décrit plus haut, pour filtrer l'une des deux bandes latérales et un polariseur pour polariser circulairement la bande latérale non filtrée.

Dans un autre mode de réalisation, on vient jouer sur le sens de polarisation de chacune de ces bandes pour que leurs champs virtuels s'additionnent. La source d'excitation optique comprend pour cela deux filtres polarisants et une lame quart d'onde agencés en cascade. Les deux filtres polarisants consistent en un premier polariseur linéaire apte à polariser verticalement l'une des bandes latérales et en un second polariseur linéaire apte à polariser horizontalement l'autre des bandes latérales. Il s'agit par exemple de polariseurs à grille de fils (*wire grid polarizer*).

La lame quart d'onde vient polariser circulairement chacune des bandes latérales respectivement dans le sens anti-horaire et dans le sens horaire. Dans la mesure où la lumière polarisée circulairement à droite induit un champ fictif de signe contraire à celui induit par la lumière polarisée circulairement à gauche, on dispose en sortie de la lame quart d'onde de bandes latérales polarisés inversement et correspondant donc à des champs fictifs qui s'ajoutent.

L'invention n'est pas limitée à un magnétomètre en tant que tel (seul ou exploité dans un réseau de magnétomètres d'un dispositif de magnétométrie) mais s'étend également au procédé d'asservissement en champ nul d'un tel magnétomètre à pompage optique. Selon ce procédé, on procède à la régulation en boucle fermée de l'éclairage d'une cavité optique délimitée par des miroirs dans laquelle est agencée la cellule par un faisceau polarisé circulairement et accordé à une longueur d'onde d'excitation décalée par rapport à la longueur d'onde de pompage. Cette régulation est réalisée de manière à induire dans la cellule, par effet Stark, l'équivalent d'un champ magnétique de compensation opposé au champ magnétique ambiant dans la direction de propagation de la lumière dans la cavité optique.

L'invention trouve application dans l'imagerie médicale du coeur et du cerveau. Elle trouve également application dans des procédés impliquant des champs magnétiques importants : détection de signaux RMN/IRM, relaxométrie, résonance quadrupolaire nucléaire (RQN) destinée à la détection d'explosifs; ainsi que comme sonde pour des blindages magnétiques actifs ou des mesures de magnéto-élasticité.

## Revendications

1. Magnétomètre (10) comprenant une cellule (1) remplie d'un gaz soumis à un champ magnétique ambiant, une source de pompage optique (2) apte à émettre en direction de la cellule un faisceau laser accordé à une longueur d'onde de pompage, un photodétecteur (3) recevant le faisceau laser ayant traversé la cellule et un système d'asservissement en boucle fermé du magnétomètre pour le faire fonctionner en champ nul, **caractérisé en ce que** ledit système d'asservissement comprend :
- une cavité optique (11) délimitée par des miroirs (M1, M2) dans laquelle est agencée la cellule (1),
- une source d'excitation optique (9) configurée pour éclairer la cavité optique avec un faisceau polarisé circulairement et accordé à une longueur d'onde d'excitation décalée par rapport à la longueur d'onde de pompage de manière à permettre d'induire dans la cellule, par effet Stark, l'équivalent d'un champ magnétique orienté selon une direction de propagation de la lumière dans la cavité optique, et
- un régulateur de boucle fermée (Vx, Vy, Vz) couplé au photodétecteur et configuré pour piloter la source d'excitation optique de manière à ce qu'elle induise dans la cellule l'équivalent d'un champ magnétique de compensation opposé au champ magnétique ambiant dans ladite direction de propagation de la lumière.

2. Magnétomètre selon la revendication 1, dans lequel la cavité optique (11) est une cavité résonante accordée à la longueur d'onde d'excitation de la source d'excitation optique.

3. Magnétomètre selon la revendication 1, dans lequel la cavité optique (11) est une cavité multi passages.

4. Magnétomètre selon l'une des revendications 1 à 3, dans lequel les miroirs (M1, M2) de la cavité optique sont formés sur les parois de la cellule (1).

5. Magnétomètre selon l'une des revendications 1 à 4, dans lequel la cavité optique (11) est agencée de manière à ce que la direction de propagation de la lumière dans la cavité optique corresponde avec un axe de mesure du magnétomètre.

6. Magnétomètre selon l'une des revendications 1 à 5, dans lequel la source d'excitation optique (9) comprend un laser configuré pour délivrer un faisceau laser accordé à la longueur d'onde d'excitation et un polariseur circulaire.

7. Magnétomètre selon la revendication 6, dans lequel l'écart entre la longueur d'onde de pompage et la longueur d'onde d'excitation est compris entre 0,25 et 2,5 fois la largeur optique à mi-hauteur de la raie de la transition atomique activée par la source de pompage optique.

8. Magnétomètre selon l'une des revendications 1 à 5, dans lequel la source d'excitation optique (9) comprend un laser configuré pour délivrer un faisceau laser accordé à la longueur d'onde de pompage et un modulateur optique apte à décaler la longueur d'onde du faisceau laser de la longueur d'onde de pompage vers la longueur d'onde d'excitation.

9. Magnétomètre selon la revendication 8, dans lequel en sortie du modulateur le faisceau laser présente deux bandes latérales de longueur d'onde respectivement au-dessus et au-dessous de la longueur d'onde de pompage, et dans lequel la distance entre les deux bandes latérales est comprise entre 0,5 et 5 fois la largeur optique à mi-hauteur de la raie de la transition atomique activée par la source de pompage optique.

10. Magnétomètre selon la revendication 9, dans lequel la source d'excitation optique (9) comprend en outre un filtre optique pour filtrer l'une des deux bandes latérales et un polariseur pour polariser circulairement la bande latérale non filtrée.

11. Magnétomètre selon la revendication 9, dans lequel la source d'excitation optique comprend en outre deux filtres polarisants et une lame quart d'onde agencés en cascade, les deux filtres polarisants consistant en un premier polariseur linéaire apte à polariser verticalement l'une des bandes latérales et en un second polariseur linéaire apte à polariser horizontalement l'autre des bandes latérales, la lame quart d'onde venant polariser circulairement chacune des bandes latérales respectivement dans le sens anti-horaire et dans le sens horaire.

12. Magnétomètre selon l'une des revendications 1 à 11, dans lequel le régulateur comprend un intégrateur (Iy, Iz, Ix).

13. Magnétomètre selon l'une des revendications 1 à 12, comprenant trois cavités optiques chacune associée à un axe de mesure du magnétomètre et éclairée par sa propre source d'excitation optique.

14. Dispositif de magnétométrie comprenant un réseau de magnétomètres chacun conforme au magnétomètre de l'une quelconque des revendications 1 à 13.

15. Procédé d'asservissement en champ nul d'un magnétomètre comprenant une cellule remplie d'un gaz soumis à un champ magnétique ambiant, une source de pompage optique apte à émettre en direction de la cellule un faisceau laser accordé à une longueur d'onde de pompage, le procédé comprenant la régulation en boucle fermé de l'éclairage d'une cavité optique délimitée par des miroirs dans laquelle est agencée la cellule par un faisceau polarisé circulairement et accordé à une longueur d'onde d'excitation décalée par rapport à la longueur d'onde de pompage de manière à induire dans la cellule, par effet Stark, l'équivalent d'un champ magnétique de compensation opposé au champ magnétique ambiant dans la direction de propagation de la lumière dans la cavité optique.

## Patentansprüche

1. Magnetometer (10), umfassend eine Zelle (1), die mit einem Gas gefüllt ist, das einem Umgebungsmagnetfeld ausgesetzt ist, eine optische Pumpquelle (2), die dazu ausgelegt ist, in Richtung der Zelle einen Laserstrahl zu emittieren, der auf eine Pumpwellenlänge abgestimmt ist, einen Fotodetektor (3), der den Laserstrahl empfängt, der die Zelle durchlaufen hat, und ein System zur Regelung in geschlossener Schleife des Magnetometers, um es im Nullfeld funktionieren zu lassen, **dadurch gekennzeichnet, dass** das Regelsystem Folgendes umfasst:
- einen optischen Hohlraum (11), der durch Spiegel (M1, M2) begrenzt ist, in dem die Zelle (1) angeordnet ist,
- eine optische Anregungsquelle (9), die dazu konfiguriert ist, den optischen Hohlraum mit einem Strahl zu beleuchten, der zirkular polarisiert und auf eine Anregungswellenlänge abgestimmt ist, die bezüglich der Pumpwellenlänge derart versetzt ist, dass es ermöglicht wird, in der Zelle mittels Stark-Effekt das Äquivalent eines Magnetfelds zu induzieren, das entlang einer Ausbreitungsrichtung des Lichts in dem optischen Hohlraum orientiert ist, und
- einen Regler in geschlossener Schleife (Vx, Vy, Vz), der mit dem Fotodetektor gekoppelt und dazu konfiguriert ist, die optische Anregungsquelle derart zu steuern, dass sie in der Zelle das Äquivalent eines magnetischen Kompensationsfelds entgegengesetzt zum Umgebungsmagnetfeld in der Ausbreitungsrichtung des Lichts induziert.

2. Magnetometer nach Anspruch 1, bei dem der optische Hohlraum (11) ein Resonanzhohlraum ist, der auf die Anregungswellenlänge der optischen Anregungsquelle abgestimmt ist.

3. Magnetometer nach Anspruch 1, bei dem der optische Hohlraum (11) ein Hohlraum mit mehreren Durchgängen ist.

4. Magnetometer nach einem der Ansprüche 1 bis 3, bei dem die Spiegel (M1, M2) des optischen Hohlraums auf den Wänden der Zelle (1) gebildet sind.

5. Magnetometer nach einem der Ansprüche 1 bis 4, bei dem der optische Hohlraum (11) derart ausgelegt ist, dass die Ausbreitungsrichtung des Lichts in dem optischen Hohlraum einer Messachse des Magnetometers entspricht.

6. Magnetometer nach einem der Ansprüche 1 bis 5, bei dem die optische Anregungsquelle (9) einen Laser umfasst, der dazu konfiguriert ist, einen Laserstrahl zu liefern, der auf die Anregungswellenlänge abgestimmt ist, und einen Zirkularpolarisator.

7. Magnetometer nach Anspruch 6, bei dem der Abstand zwischen der Pumpwellenlänge und der Anregungswellenlänge zwischen 0,25 und 2,5 Mal der optischen Breite auf halber Höhe der atomaren Übergangslinie enthalten ist, die durch die optische Pumpquelle aktiviert wird.

8. Magnetometer nach einem der Ansprüche 1 bis 5, bei dem die optische Anregungsquelle (9) einen Laser umfasst, der dazu konfiguriert ist, einen Laserstrahl zu liefern, der auf die Pumpwellenlänge abgestimmt ist, und einen optischen Modulator, der dazu ausgelegt ist, die Wellenlänge des Laserstrahls von der Pumpwellenlänge in Richtung der Anregungswellenlänge zu versetzen.

9. Magnetometer nach Anspruch 8, bei dem der Laserstrahl am Ausgang des Modulators zwei laterale Wellenlängenbänder über beziehungsweise unter der Pumpwellenlänge aufweist, und bei dem der Abstand zwischen den zwei lateralen Bändern zwischen 0,5 und 5 Mal der optischen Breite bei halber Höhe der atomaren Übergangslinie enthalten ist, die durch die optische Pumpquelle aktiviert wird.

10. Magnetometer nach Anspruch 9, bei dem die optische Anregungsquelle (9) ferner ein optisches Filter umfasst, um eines der zwei lateralen Bänder zu filtern, sowie einen Polarisator, um das nicht gefilterte laterale Band zirkular zu polarisieren.

11. Magnetometer nach Anspruch 9, bei dem die optische Anregungsquelle ferner zwei polarisierende Filter und eine Viertelwellenplatte umfasst, die in Kaskade angeordnet sind, wobei die zwei polarisierenden Filter bestehen aus einem ersten linearen Polarisator, der dazu ausgelegt ist, eines der lateralen Bänder vertikal zu polarisieren, und einem zweiten linearen Polarisator, der dazu ausgelegt ist, das andere der lateralen Bänder horizontal zu polarisieren, wobei die Viertelwellenplatte jedes der lateralen Bänder im Gegenuhrzeigersinn beziehungsweise im Uhrzeigersinn zirkular polarisiert.

12. Magnetometer nach einem der Ansprüche 1 bis 11, bei dem der Regler einen Integrator (Iy, Iz, Ix) umfasst.

13. Magnetometer nach einem der Ansprüche 1 bis 12, umfassend drei optische Hohlräume, die jeweils einer Messachse des Magnetometers zugeordnet sind und durch ihre eigene optische Anregungsquelle beleuchtet werden.

14. Magnetometrievorrichtung, umfassend ein Netz von Magnetometern, von denen jedes dem Magnetometer nach einem der Ansprüche 1 bis 13 entspricht.

15. Verfahren zum Regeln eines Magnetometers im Nullfeld, umfassend eine Zelle, die mit einem Gas gefüllt ist, das einem Umgebungsmagnetfeld ausgesetzt ist, eine optische Pumpquelle, die dazu ausgelegt ist, in Richtung der Zelle einen Laserstrahl zu emittieren, der auf eine Pumpwellenlänge abgestimmt ist, wobei das Verfahren die Regelung in geschlossener Schleife der Beleuchtung eines optischen Hohlraums umfasst, der durch Spiegel begrenzt ist, in dem die Zelle angeordnet ist, und zwar mittels eines Strahls, der zirkular polarisiert und auf eine Anregungswellenlänge abgestimmt ist, die bezüglich der Pumpwellenlänge derart versetzt ist, dass in der Zelle mittels Stark-Effekt das Äquivalent eines magnetischen Kompensationsfelds entgegengesetzt zum Umgebungsmagnetfeld in der Ausbreitungsrichtung des Lichts in den optischen Hohlraum induziert wird.

## Claims

1. A magnetometer (10) comprising a cell (1) filled with a gas subjected to an ambient magnetic field, an optical pumping source (2) able to emit towards the cell a laser beam tuned to a pumping wavelength, a photodetector (3) receiving the laser beam that passed through the cell and a closed loop control system for the magnetometer to operate it in a zero field, **characterised in that** said control system comprises:
- an optical cavity (11) delimited by mirrors (M1, M2), cavity in which the cell (1) is arranged,
- an optical excitation source (9) configured to light the optical cavity with a circularly polarised beam and tuned to an excitation wavelength shifted with respect to the pumping wavelength so as to allow induction in the cell, by Stark effect, of the equivalent of a magnetic field oriented along a direction of propagation of light in the optical cavity, and
- a closed loop regulator (Vx, Vy, Vz) coupled to the photodetector and configured to drive the optical excitation source such that it induces in the cell the equivalent of a compensation magnetic field opposite to the ambient magnetic field in said direction of propagation of light.

2. The magnetometer according to claim 1, wherein the optical cavity (11) is a resonant cavity tuned to the excitation wavelength of the optical excitation source.

3. The magnetometer according to claim 1, wherein the optical cavity (11) is a multi-passage cavity.

4. The magnetometer according to one of claims 1 to 3, wherein the mirrors (M1, M2) of the optical cavity are formed on the walls of the cell (1).

5. The magnetometer according to one of claims 1 to 4, wherein the optical cavity (11) is arranged such that the direction of propagation of light in the optical cavity corresponds with a measurement axis of the magnetometer.

6. The magnetometer according to one of claims 1 to 5, wherein the optical excitation source (9) comprises a laser configured to deliver a laser beam tuned to the excitation wavelength and a circular polariser.

7. The magnetometer according to claim 6, wherein the deviation between the pumping wavelength and the excitation wavelength is between 0.25 and 2.5 times the optical full width at half maximum of the atomic transition line activated by the optical pumping source.

8. The magnetometer according to one of claims 1 to 5, wherein the optical excitation source (9) comprises a laser configured to deliver a laser beam tuned to the pumping wavelength and an optical modulator able to shift the wavelength of the laser beam from the pumping wavelength to the excitation wavelength.

9. The magnetometer according to claim 8, wherein at the outlet of the modulator, the laser beam has two side wavelength bands respectively above and below the pumping wavelength, and wherein the distance between both side bands is between 0.5 and 5 times the optical full width at half maximum of the atomic transition line activated by the optical pumping source.

10. The magnetometer according to claim 9, wherein the optical excitation source (9) further comprises an optical filter to filter one of both side bands and a polariser to circularly polarise the side band not filtered.

11. The magnetometer according to claim 9, wherein the optical excitation source further comprises two polarising filters and a quarter wave plate arranged in cascade, both polarising filters consisting of a first linear polariser able to vertically polarise one of the side bands and of a second linear polariser able to horizontally polarise the other of the side bands, the quarter wave plate circularly polarising each of the side bands counter-clockwise and clockwise respectively.

12. The magnetometer according to one of claims 1 to 11, wherein the regulator comprises an integrator (Iy, Iz, Ix).

13. The magnetometer according to one of claims 1 to 12, comprising three optical cavities each associated with a measurement axis of the magnetometer and lighted by its own optical excitation source.

14. A magnetometer device comprising an array of magnetometers each in accordance with the magnetometer of any of claims 1 to 13.

15. A method for controlling in a zero field a magnetometer comprising a cell filled with a gas subjected to an ambient magnetic field, an optical pumping source able to emit towards the cell a laser beam tuned to a pumping wavelength, the method comprising regulating in a closed loop the lighting of an optical cavity delimited by mirrors in which the cell is arranged by a circularly polarised beam and tuned to an excitation wavelength shifted with respect to the pumping wavelength so as to induce in the cell, by Stark effect, the equivalent of a compensation magnetic field opposite to the ambient magnetic field in the direction of propagation of light in the optical cavity.
